# EUROPÄISCHE PATENTSCHRIFT

(11) **EP 2 149 797 B1**
(45) Veröffentlichungstag und Bekanntmachung des Hinweises auf die Patenterteilung: **02.05.2012**
(21) Anmeldenummer: 08013832.4
(22) Anmeldetag: 01.08.2008
(51) Int. Cl.: G01R 33/00, G01R 33/07, G01R 33/02, G01R 33/028, G01R 33/06

(54) **Verfahren und Vorrichtung zur Messung eines Winkels, unter dem ein Magnetfeld in einer Ebene relativ zu einer Bezugsachse angeordnet ist**
Method and device for determining an angle, under which a magnetic field is arranged in a plane relative to a reference axis
Procédé et dispositif de mesure d'un angle selon lequel un champ magnétique est agencé dans un plan par rapport à un axe de référence

(43) Veröffentlichungstag der Anmeldung: 03.02.2010
(73) Patentinhaber: Micronas GmbH, 79108 Freiburg i. Br. (DE)
(72) Erfinder: Muthers, David, Dr.-Ing., 79111 Freiburg (DE)
(74) Vertreter: Koch, Bertram

(56) Entgegenhaltungen:
- WO-A-96/16316
- WO-A-03/012478
- US-A- 3 903 610
- US-A- 4 013 946
- US-A- 4 536 685
- US-A1- 2003 132 761
- REYMOND S ET AL: "True 2D CMOS integrated Hall sensor" SENSORS, 2007 IEEE, IEEE, PI, 28. Oktober 2007 (2007-10-28), Seiten 860-863, XP031221197 ISBN: 978-1-4244-1261-7
- PHILIPS SEMICONDUCTORS: "DATA SHEET UZZ9001 - Sensor Conditioning Electronic" DISCRETE SEMICONDUCTORS - PRODUCT SPECIFICATION, 27. November 2000 (2000-11-27), Seiten 1-16, XP002522766

## Beschreibung

Die Erfindung betrifft eine Vorrichtung zur Messung eines Winkels, unter dem ein Magnetfeld in einer Ebene relativ zu einer Bezugsachse angeordnet ist, mit mindestens zwei Magnetfeldsensoren, die mit ihren Messachsen in und/oder parallel zu der Ebene angeordnet und quer zueinander orientiert sind. Ferner betrifft die Erfindung ein Verfahren zur Messung eines Winkels, unter dem ein Magnetfeld in einer Ebene relativ zu einer Bezugsachse angeordnet ist, wobei eine erste Magnetfeldkomponente und eine quer dazu angeordnete zweite Magnetfeldkomponente in und/oder parallel zu der Ebene gemessen werden.

Aus Reymond, S. et al., "True 2D CMOS integrated Hall sensor", IEEE SENSORS 2007 Conference, Seiten 860-863 ist eine Vorrichtung der eingangs genannten Art bekannt, die ein Halbleitersubstrat aufweist, in das als Magnetfeldsensoren 64 sogenannter vertikaler Hallsensoren integriert sind. Die Magnetfeldsensoren sind in gleichmäßigen Abständen zueinander derart auf einem in der Chipebene des Halbleitersubstrats liegenden Kreisring angeordnet, dass die Ebenen, in denen sich die Magnetfeldsensoren erstrecken, jeweils radial zu einer gedachten Mittelachse angeordnet sind, die durch den Mittelpunkt des Kreisrings verläuft und orthogonal zur Chipebene angeordnet ist. Die Magnetfeldsensoren sind derart mit einer Abtasteinrichtung verbunden, dass die Messsignale der einzelnen Magnetfeldsensoren nacheinander an einen differentiellen Ausgangsanschluss für ein Rotationsabtastsignal anlegbar sind. Die Magnetfeldsensoren werden also zyklisch rotierend nacheinander ausgelesen. Der differentielle Ausgangsanschluss ist über einen differentiellen Verstärker mit einem in das Halbleitersubstrat integrierten Tiefpass verbunden. Mit Hilfe des Tiefpasses wird das analoge Ausgangssignal des Verstärkers zu einem etwa sinusförmigen Signal geglättet. Der Nulldurchgang des so erhaltenen, analogen Messsignals wird ermittelt und aus der Nulldurchgangsstelle wird der Winkel, unter dem ein das Halbleitersubstrat durchflutendes Magnetfeld in der Chipebene relativ zu einer Bezugsachse angeordnet ist, bestimmt.

Die Vorrichtung hat den Nachteil, dass das Auslesen der vielen Magnetfeldsensoren zeitaufwändig ist. Daher ermöglicht die Vorrichtung trotz des hohen Schaltungsaufwands nur eine geringe Bandbreite. Ungünstig ist außerdem, dass der nicht gegengekoppelte, analoge Tiefpass in Bezug auf Linearität und Frequenzgang hohe Anforderungen erfüllen muss, was einen hohen Flächenverbrauch auf dem Halbleiterchip und eine hohe Leistungsaufnahme bedeutet.

Aus DATA SHEET UZZ9001, Sensor Conditioning Electronic, Product Specification, Philips Semiconductors, 27, November 2000 ist ferner eine Vorrichtung der eingangs genannten Art bekannt, die als Magnetfeldsensoren zwei in einen Halbleiterchip integrierte magnetoresistive Sensoren aufweist, die mit ihren Messachsen in einer Ebene rechtwinklig zueinander angeordnet sind. Jeder Magnetfeldsensor ist jeweils mit einem Analog-Digital-Konverter verbunden, der als Sigma-Delta Modulator ausgestaltet ist. Jedem Analog-Digital-Konverter ist jeweils ein Dezimationsfilter nachgeschaltet, an dessen Ausgang ein Magnetfeldmesswert in Form eines 15-bit Digitalworts ausgegeben wird. Die Digitalwörter werden an ein Rechenwerk übermittelt, das den Winkel, unter dem ein das Halbleitersubstrat durchflutendes Magnetfeld in der Chipebene relativ zu einer Bezugsachse angeordnet ist, aus dem Arcustangens des Quotienten der Digitalwörter berechnet. Auch hier ist der verhältnismäßig große Schaltungsaufwand nachteilig. Durch das Berechnen des Magnetfeld-Winkel ergibt sich eine Latenz, die beim Einsatz der Vorrichtung in einem Regelkreis nachteilig ist.

Weitere Vorrichtungen sind aus der US 4 536 685 A, der WO 96/ 16316 A, der US 2003 / 132 761 A1, der US 3 903 610 und der US 4 013 946 bekannt. Hierbei offenbart die US 4 536 685 A zwei Halleffektsensoren und eine PLL Regelschleife zum Erfassen einer Rotation.

Es besteht deshalb die Aufgabe, eine Vorrichtung der eingangs genannten Art zu schaffen, die einen einfachen Aufbau und eine hohe Messgenauigkeit ermöglicht. Außerdem besteht die Aufgabe, ein Verfahren der eingangs genannten Art zu schaffen, mit dem der Winkel auf einfache Weise mit großer Präzision bestimmt werden kann.

Bezüglich der Vorrichtung wird die Aufgabe dadurch gelöst, dass die Vorrichtung einen PLL-Phasenregelkreis mit einem in einer Phasenregelschleife angeordneten Nachlaufoszillator aufweist, dass der Nachlaufoszillator mindestens einen Oszillatorausgang für ein Digitalschwingungssignal hat, dass die Magnetfeldsensoren derart mit der Phasenregelschleife gekoppelt sind, dass das Digitalschwingungssignal phasensynchron zu einem durch rotierendes Abtasten der Messsignale der Magnetfeldsensoren gebildeten Rotationsabtastsignai ist, und dass der Oszillatorausgang zur Bestimmung der Phasenlage des Digitalschwingungssignals mit einem Phasenlagedetektor verbunden ist.

Die Vorrichtung weist also einen einfach aufgebauten, kostengünstig herstellbaren Phase-Locked Loop (PLL) Phasenregelkreis auf, der bezüglich der Phase seines Digitalschwingungssignals zur Phase eines durch rotierendes Auslesen der Messsignalausgänge der Magnetfeldsensoren gebildeten Rotationsabtastsignals synchron ist. Dabei wird unter "synchron" verstanden, dass die Phasenlage des Digitalschwingungssignals mit der des Rotationsabtastsignals identisch oder um einen bekannten, konstanten Winkel verschoben ist. Somit kann der Winkel, unter dem das Magnetfeld in der von den Achsen der Magnetfeldsensoren aufgespannten Ebene relativ zur Bezugsachse angeordnet ist, auf einfache Weise durch Bestimmung der Phasenlage des Digitalschwingungssignals ermittelt werden.

Vorteilhaft ist, wenn die Magnetfeldsensoren derart mit einer Abtasteinrichtung verbunden sind, dass die Messsignale der einzelnen Magnetfeldsensoren nacheinander an einen Ausgangsanschluss für das Rotationsabtastsignal anlegbar sind, und wenn der Ausgangsanschluss mit einem Synchronisationssignaleingang des PLL-Phasenregelkreises verbunden ist. Dabei kann die Abtasteinrichtung den Messsignalanschlüssen der Magnetfeldsensoren nachgeschaltet sein. Ist aber auch denkbar, dass mit Hilfe der Abtasteinrichtung die Magnetfeldsensoren oder Schaltungsteile davon ein- und ausgeschaltet werden, um den entsprechenden Magnetfeldsensor zu aktivieren oder zu deaktivieren.

Bei einer zweckmäßigen Ausgestaltung der Erfindung hat jeder Magnetfeldsensor jeweils einen mit einem Eingangsanschluss eines Multiplexers verbundenen Messsignalausgang, wobei der Multiplexer einen mit den einzelnen Eingangsanschlüssen verbindbareren Ausgang aufweist der den Ausgangsanschluss für das Rotationsabtastsignal bildet. Die Vorrichtung ist dann noch einfacher aufgebaut.

Bei einer bevorzugten Ausführungsform der Erfindung ist der Ausgangsanschluss für das Rotationsabtastsignal mit einem ersten Eingang eines Frequenzmischers und der Oszillatorausgang des Nachlaufuszillators mit einem zweiten Eingang des Frequenzmischers verbunden, wobei ein Mischerausgang des Frequenzmischers über mindestens einen Tiefpass und wenigstens einen getakteten Komparator an einem Frequenzsteuereingang des Nachlaufoszillators angeschlossen ist. Dabei wird mit Hilfe des Frequenzmischers und des diesem nachgeschalteten Tiefpasses ein analoges Signal für Differenzfrequenz zwischen der Rotationsfrequenz des Rotationsabtastsignals und derjenigen des Digitalschwingungssignals generiert. Dieses wird dann mit Hilfe des Komparators in ein digitales Steuersignal für den Nachlaufoszillator konvertiert. Der analoge Tiefpass der Phasenregelschleife ermöglicht eine hohe Schleifenverstärkung im Signalband der Winkeländerung bei gleichzeitig niedriger Schleifenverstärkung bei der Rotationsfrequenz, so dass eine spektrale Verschiebung des Quantisierungsrauschens aus dem Signalband hinaus stattfindet, das sogenannte noise shaping. Die Ordnung und der Frequenzgang des Tiefpasses können wie bei jedem Sigma-Delta-Modulator an die Gegebenheiten der Applikation angepasst sein.

Vorteilhaft ist, wenn der Phasenlagedetektor einen Quadrantendetektor aufweist, der einen ersten Polaritätsdetektor und einen zweiten Polarisationsdetektor hat, dass ein Eingang des ersten Polarisationsdetektors mit einem Messsignalausgang eines ersten Magnetfeldsensors und ein Eingang des zweiten Polarisationsdetektors mit einem Messsignalausgang eines zweiten Magnetfeldsensors verbunden ist, und wenn der zweite Magnetfeldsensor mit seiner Messachse orthogonal zur Messachse des ersten Magnetfeldsensors angeordnet ist. Dadurch ist es möglich, den gemessenen Magnetfeld-Winkel eindeutig einem Quadranten zuzuordnen und somit den Betrag und das Vorzeichen des Winkels zu bestimmen.

Bei einer Weiterbildung der Erfindung sind die Magnetfeldsensoren Hall-Sensoren, die eine Umschalteinrichtung zur Orthogonalumschaltung des Hallsensor-Versorgungsstroms und der Hallspannungsabgriffe aufweisen, wobei die Umschalteinrichtung einen mit einem Taktgeber verbundenen Takteingang für ein Umschalttaktsignal aufweist. Die Erfindung kann also auch mit der sogenannten Spinning-Current-Technik kombiniert werden.

Vorteilhaft ist, wenn die Taktfrequenz des Umschalttaktsignals mindestens eines Magnetfeldsensors derart gewählt ist, dass innerhalb eines Abtastzyklus, während dem das Messsignal dieses Magnetfeldsensors mit der Phasenregelschleife gekoppelt ist, die Umschalteinrichtung zur Orthogonalumschaltung mindestens zwei und bevorzugt vier unterschiedliche Schaltzustände einnimmt. Durch Mittelung der vier möglichen Polungen der Hallsensoren kann eine deutliche Reduzierung eines bei der Messung auftretenden Offset erreicht werden. Die Mischerbandbreite erhöht sich aufgrund der höheren Taktfrequenz des Umschalttaktsignals.

Bei eine anderen vorteilhaften Ausgestaltung der Erfindung ist die Taktfrequenz des Umschalttaktsignals mindestens eines Magnetfeldsensors derart gewählt, dass der Hallsensor-Versorgungsstrom des Magnetfeldsensors nach jedem Rotationsumlauf des Rotationsabtastsignals einmal seine Richtung ändert. Ein Spinning-Umlauf ist dann nach vier Rotationsumläufen des Rotationsabtastsignals beendet. Die Spinning-Frequenz fₛₚᵢₙ beträgt dann fₛₚᵢₙ = (fᵣₒₜ /4) = (f_{clk}/4N), wobei fᵣₒₜ die Rotationsfrequenz des Rotationsabtastsignals und f_{cik} die Taktfrequenz eines Taktgebers ist. Die Einzelphasenoffsets der Magnetfeldsensoren werden so von f=0 zu fₛₚᵢₙ verschoben. Ein Dezimierungsfilter kann diese Frequenzanteile unterdrücken, so dass die Mittelung der Sensoroffsets ohne Mehraufwand möglich ist.

Vorzugsweise weist der Komparator einen mit einem Taktsignalgeber verbundenen Taktsignaleingang auf, wobei der Taktsignalgeber derart ausgestaltet ist, dass die Taktfrequenz eines an dem Taktsignaleingang anliegenden Komparatortaktsignals mindestens doppelt so groß ist wie die Umlauffrequenz des Rotationsabtastsignals. Dabei wird die Erkenntnis ausgenutzt, dass das Ausgangssignal des Frequenzmischers bei eingerasteter Phasenregelschleife mit der Frequenz fₘᵢₓ = 2 fᵣₒₜ oszilliert. Durch die schnellere Taktung des Komparators kann der Magnetfeld-Winkel noch schneller gemessen werden.

Bei einer vorteilhaften Ausgestaltung der Erfindung weist der Nachlaufoszillator eine der Anzahl der mit ihren Messachsen quer zueinander angeordneten Magnetfeldsensoren entsprechende Anzahl Oszillatorausgänge für zueinander phasenverschobene Digitalschwingungssignale auf, wobei in der Phasenregelschleife eine der genannten Anzahl entsprechende Anzahl Frequenzmischer angeordnet sind, wobei jeder Frequenzmischer jeweils einen mit einem Messsignalausgang eines dem Frequenzmischer zugeordneten Magnetfeldsensors verbundenen ersten Eingang und einen mit einem der Oszillatorausgänge verbundenen zweiten Eingang aufweist, und wobei die Mischerausgänge der Frequenzmischer über ein Addierglied, mindestens einen Tiefpass und wenigstens einen getakteten Komparator an dem Frequenzsteuereingang des Nachlaufoszillators angeschlossen sind. Die Abtstrate des Komparators hat dabei bevorzugt die vierfache Frequenz des Rotationsumlaufs. Dadurch kann der Magnetfeld-Winkel noch schneller gemessen werden.

Erwähnt werden soll noch, dass die Messgenauigkeit der Vorrichtung auch dadurch erhöht werden kann, dass für jede Messachse jeweils mehrere parallel zueinander angeordnete Magnetfeldsensoren vorgesehen sind, und dass die Messsignale dieser Magnetfeldsensoren gemittelt werden.

Bezüglich des Verfahrens der eingangs genannten Art wird die vorstehend genannte Aufgabe dadurch gelöst, dass mindestens ein Digitalschwingungssignal erzeugt wird, dass die Phasenlage des Digitalschwingungssignals derart geregelt wird, dass sie zu der Phasenlage eines durch rotierendes Abtasten der Messsignale der Magnetfeldsensoren gebildeten Rotationsabtastsignals phasensynchron ist, und dass Winkel aus der Phasenlage des Digitalschwingungssignals ermittelt wird.

In vorteilhafter Weise ist es dadurch möglich, den Winkel, unter dem das Magnetfeld in der von den Achsen der Magnetfeldsensoren aufgespannten Ebene relativ zur Bezugsachse angeordnet ist, auf einfache Weise durch Bestimmung der Phasenlage des Digitalschwingungssignals zu ermittelten.

Nachfolgend sind Ausführungsbeispiele der Erfindung anhand der Zeichnung näher erläutert. Es zeigen:
- Fig. 1: ein erstes Ausführungsbeispiel einer Vorrichtung zur Messung eines Winkels, unter dem ein Magnetfeld in einer Ebene relativ zu einer Be- zugsachse angeordnet ist,
- Fig. 2: ein zweites Ausführungsbeispiel der Vorrichtung, und
- Fig. 3: eine graphische Darstellung eines Rotationsabtastsignals Vᵣₒₜ, eines Digitalschwingungssignals Svco und eines Schwingungssignals Vₘᵢₓ am Ausgang eines Frequenzmischers der Vorrichtung, wobei auf der Abszis- se die Zeit und auf der Ordinate die Amplitude des entsprechenden Signals aufgetragen ist.

Eine im Ganzen mit 1 bezeichnete Vorrichtung zur Messung eines Winkels, unter dem ein Magnetfeld B in einer Ebene 2 relativ zu einer Bezugsachse angeordnet ist, weist zwei als Hallsensoren ausgestaltete Magnetfeldsensoren 3, 4 auf, die mit ihren Messachsen orthogonal zueinander angeordnet sind. Ein erster Magnetfeldsensor 3 ist für eine x-Komponente des Magnetfelds B und ein zweiter Magnetfeldsensor 4 für eine y-Komponente des Magnetfelds B empfindlich.

Die Magnetfeldsensoren 3, 4 sind in einen in der Zeichnung nicht näher dargestellten Halbleiterchip integriert. Sie haben jeweils eine monolithisch in ein Halbleitersubstrat integrierte Hallplatte, die mit ihrer Erstreckungsebene rechtwinklig zur Ebene des Halbleiterchips angeordnet ist.

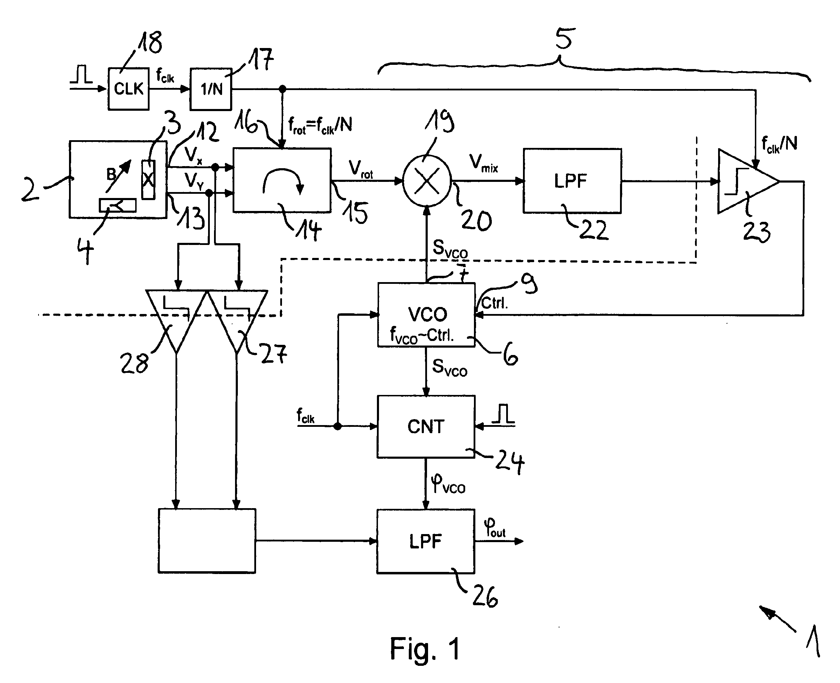

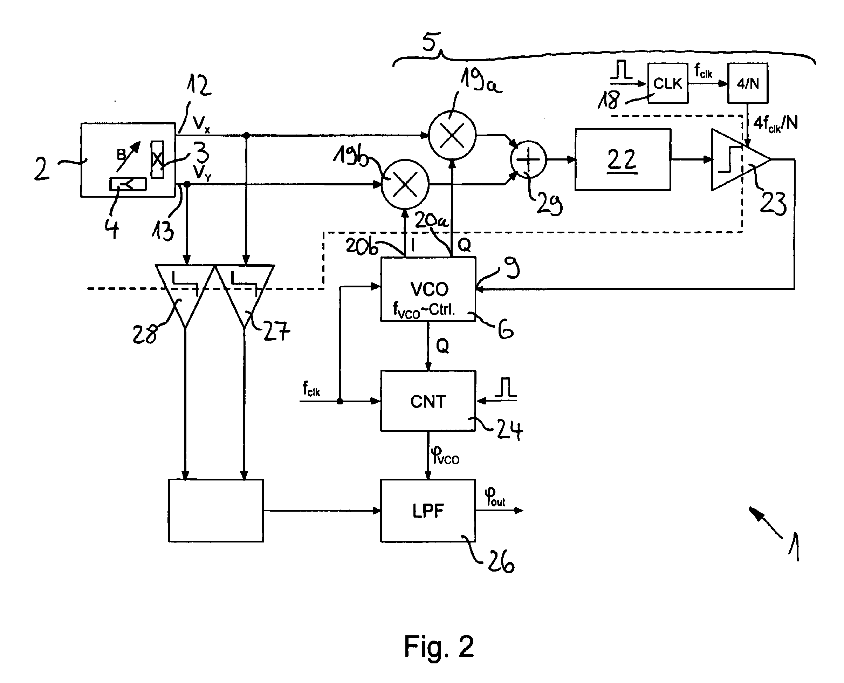

In Fig. 1 und 2 ist erkennbar, dass die Vorrichtung 1 einen PLL-Phasenregelkreis 5 mit einem in einer Phasenregelschleife aufweist, in der ein Nachlaufoszillator 6 angeordnet ist. Der Nachlaufoszillator 6 hat bei dem Ausführungsbeispiel gemäß Fig. 1 einen Oszillatorausgang 7 für ein etwa rechteckförmiges Digitalschwingungssignal 8. Zum Einstellen der Grundfrequenz des Digitalschwingungssignals 8 hat der Nachlaufoszillator 6 einen Frequenzsteuereingang 9. Die Grundfrequenz des Digitalschwingungssignals 8 ist von einer an dem Frequenzsteuereingang 9 anliegenden Spannung abhängig.

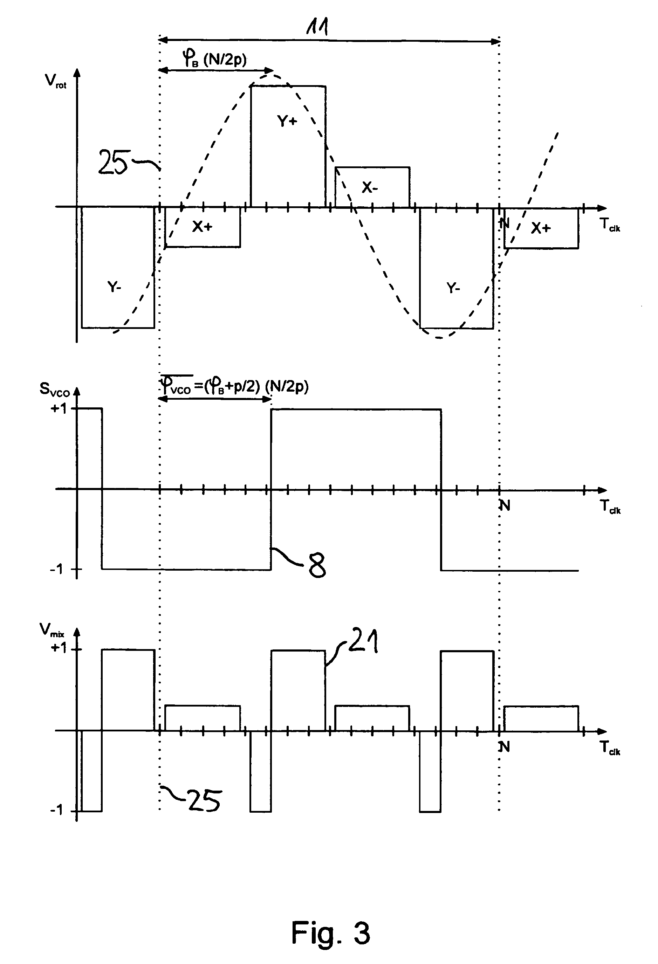

Die Magnetfeldsensoren 3, 4 sind derart mit der Phasenregelschleife gekoppelt, dass das Digitalschwingungssignal phasensynchron zu einem durch rotierendes Abtasten der Messsignale der Magnetfeldsensoren 3, 4 gebildeten Rotationsabtastsignal 10 ist. In Fig. 3 sind die im Rotationsabtastsignal 10 enthaltenen, vom Messsignal des ersten Magnetfeldsensors 3 abgetasteten Abtastwerte jeweils mit X+ bzw. X- und die vom Messsignal des zweiten Magnetfeldsensors 4 abgetasteten Abtastwerte jeweils mit Y+ bzw. Y- bezeichnet. Deutlich ist erkennbar, dass bei jedem Rotationsumlauf 11 des Rotationsabtastsignals 10 jeweils Abtastwerte X+, Y+, X-, Y-, die unterschiedlichen Magnetfeldsensoren 3, 4 zugeordnet sind, zyklisch aufeinanderfolgen. In Fig. 3 ist außerdem eine dem Rotationsabtastsignal 10 zugeordnete sinusförmige. Kurve strichliniert dargestellt, auf der die abgetasteten Messwerte liegen.

Bei dem in Fig. 1 gezeigten Ausführungsbeispiel sind die Messsignalausgänge 12, 13 der Magnetfeldsensoren 3, 4 jeweils einen mit einem Eingangsanschluss eines Multiplexers 14 verbundenen. Mit Hilfe des Multiplexers 14 werden die Messsignalausgänge 12, 13 jeweils nacheinander zyklisch mit einem an dem Multiplexer 14 vorgesehenen Ausgangsanschluss 15 für das Rotationsabtastsignal 10 verbunden. In Fig. 1 ist außerdem erkennbar, dass der Multiplexer 14 einen Steuereingang 16 aufweist, an dem ein Rotationstaktsignal anliegt. Das Rotationstaktsignal wird mit Hilfe eines Frequenzteilers 17 aus einem Systemtakt eines Taktsignalgebers 18 gebildet. Die Frequenz des Rotationstaktsignals ist in Fig. 1 mit fᵣₒₜ und die Frequenz des Systemtakts ist mit f_{clk} bezeichnet. Das Teilungsverhältnis N des Frequenzteilers 17 entspricht der Anzahl der Taktpulse, die ein Rotationsumlauf dauert.

Der Ausgangsanschluss 15 für das Rotationsabtastsignal 10 ist mit einem als Synchronisafionssignaleingang für den Phasenregelkreis 5 dienenden ersten Eingang eines Frequenzmischers 19 und der Oszillatorausgang 7 des Nachlaufoszillators 6 mit einem zweiten Eingang des Frequenzmischers 19 verbunden. An einem Mischerausgang 20 des Frequenzmischers 19 liegt ein Mischsignal 21 an, das dem Produkt aus dem Rotationsabtastsignal Vᵣₒₜ und dem Digitalschwingungssignal 8 entspricht (Fig. 3).

Der Mischerausgang 20 des Frequenzmischers 19 ist über einen analogen Tiefpass 22 mit einem Eingang eines mit dem Rotationstaktsignal getakteten Komparators 23 verbunden. Der Komparator bewertet nach jedem Rotationsumlauf das analoge gefilterte Signal Seine Auflösung kann im einfachsten Fall 1 bit betragen. Am Ausgang des Komparators 23 liegt ein Digitalsignal an, das zur Bildung einer Regelschleife dem Frequenzsteuereingang 9 des Nachlaufoszillators 6 zugeführt wird.

In Fig. 3 ist erkennbar, dass das Digitalschwingungssignal 8 bei eingerastetem Phasenregelkreis phasensynchron zum Rotationsabtastsignal 10 bzw. zu der strichliniert dargestellten sinusförmigen Kurve ist. Aufgrund der besonderen Eigenschaften des Nachlaufoszillators ergibt sich zwischen dem Digitalschwingungssignal 8 und dem Rotationsabtastsignal 10 ein Phasenversatz von etwa 90°.

Zur Bestimmung des Winkels, unter dem das Magnetfeld B in der Ebene 2 relativ zur Bezugsachse angeordnet ist, weist die Vorrichtung 1 einen Phasenlagedetektor auf. Diese hat einen Zähler 24 für die Taktimpulse des Systemtakts. Der Zähler 24 wird durch einen Startimpuls, der eine der Bezugsachse für die Winkelmessung entsprechende virtuelle Nullphasenlage 25 markiert, gestartet. Der Zähler 24 stoppt, sobald in dem Digitalschwingungssignal eine Flanke bzw. einen Nulldurchgang auftritt. Am Ausgang des Zählers 24 liegt ein dem Phasenwinkel des Digitalschwingungssignal 8 entsprechendes Digitalsignal ϕ_{vco} an. Der Ausgang des Zählers 24 ist mit einem ersten Eingang eines Tiefpassfilters 26 verbunden.

Der Phasenlagedetektor weist ferner einen Quadrantendetektor auf, der einen ersten Polaritätsdetektor 27 und einen zweiten Polarisationsdetektor 28 hat. Ein Eingang des ersten Polarisationsdetektors 27 ist mit dem Messsignalausgang 12 des ersten Magnetfeldsensors 3 und ein Eingang des zweiten Polarisationsdetektors 28 mit dem Messsignalausgang 1 3 eines zweiten Magnetfeldsensors 4 verbunden.

Ein Ausgang des Phasenlagedetektors ist mit einem zweiten Eingang des Tiefpassfilters 26 verbunden. Am Ausgang des Tiefpassfilters 26 liegt ein dem Winkel des Magnetfelds entsprechendes Messsignal ϕₒᵤₜ an.

In Fig. 3 ist ersichtlich, dass das Mischerausgangssignal Vₘᵢₓ bei eingerasteter Phasenregelschleife mit der Frequenz fₘᵢₓ = 2fᵣₒₜ oszilliert. in Weglassen der Rotationsphasen 2 und 3 ist also möglich, ohne die Funktionalität zu beeinflussen. Der Nachlaufoszillator 6 führt dann nur halbe Perioden aus. Der Komparator wird ebenfalls mit der Frequenz fₖₒₘₚ = 2f_{clk}/N doppelt so schnell getaktet, so dass sich die Schleifenbandbreite und die Ausleserate verdoppeln.

Eine weitere Verdopplung der Schleifenbandbreite ist mit dem in Fig. 2 gezeigten Ausführungsbeispiel möglich. Bei diesem weist der Nachlaufoszillator 6 Oszillatorausgänge 7a, 7b für zwei Digitalschwingungssignale auf Ein erstes Digitalschwingungssignal liegt an einem ersten Oszillatorausgang 7a und ein zweites Digitalschwingungssignal an einem zweiten Oszillatorausgang 7b des Nachlaufoszillators 6 an. Dabei sind das erste Digitalschwingungssignal und das zweite Digitalschwingungssignal um 90° phasenverschoben zueinander (Quadratursignale).

In Fig. 2 ist außerdem erkennbar, dass in der Phasenregelschleife zwei Frequenzmischer 19a, 19b angeordnet sind. Ein erster Eingang eines ersten Frequenzmischers 19a ist mit dem Messsignalausgang 12 des ersten Magnetfeldsensors 3 und ein zweiter Eingang des ersten Frequenzmischers 19a mit dem ersten Oszillatorausgang 7a verbunden. In entsprechender Weise ist erster Eingang eines zweiten Frequenzmischers 19b ist mit dem Messsignalausgang 13 des zweiten Magnetfeldsensor 4 und ein zweiter Eingang des zweiten Frequenzmischers 19b mit dem zweiten Oszillatorausgang 7b verbunden. Der in Fig. 1 vorgesehene Multiplexer 14 bzw. Rotationsschalter entfällt also in Fig. 2.

Die Mischerausgänge 20a, 20b der Frequenzmischer 19a, 19b sind jeweils mit einem Eingang eines Addierglieds 29 verbunden. Der Ausgang des Addierglieds 29 ist über einen analogen Tiefpass 22 mit einem Eingang eines mit einem Taktsignal getakteten Komparators 23 verbunden. Die Frequenz des Taktsignals ist vier mal so groß wie die Taktfrequenz f_{clk} des Taktgebers 18, dividiert durch Anzahl N der Taktpulse, die ein Rotationsumlauf dauert Die Abtastrate fₛ des Nachlaufoszillators 6 beträgt dann fₛ = 4f_{clk}/N, die Auflösung beträgt weiterhin Id(N) bit

Der Phasenlagedetektor in Fig. 2 entspricht dem von Fig. 1, weshalb insoweit auf die dortige Beschreibung verwiesen wirde.

## Patentansprüche

1. Vorrichtung (1) zur Messung eines Winkels, unter dem ein Magnetfeld (B) in einer Ebene (2) relativ zu einer Bezugsachse angeordnet ist, mit mindestens zwei Magnetfeldsensoren (2, 4), die mit ihren Messachsen in und/oder parallel zu der Ebene (2) angeordnet und quer zueinander orientiert sind,
mit einem PLL-Phasenregelkreis (5) mit einer Phasenregelschleife **dadurch gekennzeichnet, dass**
die Phasenregelschleife einen Frequenzmischer (19) und einen getakteten Komparator (23), der mit einem Nachlaufoszillator (6) verschaltet ist, aufweist, dass der Nachlaufoszillator (6) mindestens einen mit dem Frequenzmischer (19) verbundenen Oszillatorausgang (7) für ein Digitalschwingungssignal (8) hat, dass die Magnetfeldsensoren (3, 4) derart mit der Phasenregelschleife gekoppelt sind, dass das Digitalschwingungssignal (8) phasensynchron zu einem durch rotierendes Abtasten der Messsignale der Magnetfeldsensoren (3, 4) gebildeten Rotationsabtastsignal (10) ist, und dass der Oszillatorausgang (7) zur Bestimmung der Phasenlage des Digitalschwingungssignals (8) mit einem Phasenlagedetektor verbunden ist.

2. Vorrichtung (1) nach Anspruch 1, **dadurch gekennzeichnet, dass** die Magnetfeldsensoren (3, 4) derart mit einer Abtasteinrichtung verbunden sind, dass die Messsignale der einzelnen Magnetfeldsensoren (3, 4) nacheinander an einen Ausgangsanschluss (15) für das Rotationsabtastsignal (10) anlegbar sind, und dass der Ausgangsanschluss (15) mit einem Synchronisationssignaleingang des PLL-Phasenregelkreises (5) verbunden ist.

3. Vorrichtung (1) nach Anspruch 1 oder 2, **dadurch gekennzeichnet, dass** jeder Magnetfeldsensor (3, 4) jeweils einen mit einem Eingangsanschluss eines Multiplexers (14) verbundenen Messsignalausgang hat, und dass der Multiplexer (14) einen mit den einzelnen Eingangsanschlüssen verbindbareren Ausgang aufweist, der den Ausgangsanschluss (15) für das Rotationsabtastsignal (10) bildet.

4. Vorrichtung (1) nach einem der Ansprüche 1 bis 3, **dadurch gekennzeichnet, dass** der Ausgangsanschluss (15) für das Rotationsabtastsignal (10) mit einem ersten Eingang des Frequenzmischers (19) und der Oszillatorausgang (7) des Nachlaufoszillators (6) mit einem zweiten Eingang des Frequenzmischers (19) verbunden ist, und dass ein Mischerausgang (20) des Frequenzmischers (19) über mindestens einen Tiefpass (22) und des getakteten Komparator (23) an einem Frequenzsteuereingang (9) des Nachlaufoszillators (6) angeschlossen ist.

5. Vorrichtung (1) nach einem der Ansprüche 1 bis 4, **dadurch gekennzeichnet, dass** der Phasenlagedetektor einen Quadrantendetektor aufweist, der einen ersten Polaritätsdetektor (27) und einen zweiten Polarisationsdetektor (28) hat, dass ein Eingang des ersten Polarisationsdetektors (27) mit einem Messsignalausgang (12) eines ersten Magnetfeldsensors (3) und ein Eingang des zweiten Polarisationsdetektors (28) mit einem Messsignalausgang (13) eines zweiten Magnetfeldsensors (4) verbunden ist, und dass der zweite Magnetfeldsensor (4) mit seiner Messachse orthogonal zur Messachse des ersten Magnetfeldsensors (3) angeordnet ist.

6. Vorrichtung (1) nach einem der Ansprüche 1 bis 5, **dadurch gekennzeichnet dass** die Magnetfeldsensoren (3, 4) Hall-Sensoren sind, die eine Umschalteinrichtung zur Orthogonalumschaltung des Hallsensor-Versorgungsstroms und der Hallspannungsabgriffe aufweisen, und dass die Umschalteinrichtung einen mit einem Taktgeber verbundenen Takteingang für ein Umschalttaktsignal aufweist.

7. Vorrichtung (1) nach einem der Ansprüche 1 bis 6, **dadurch gekennzeichnet, dass** die Taktfrequenz des Umschalttaktsignals mindestens eines Magnetfeldsensors (3, 4) derart gewählt ist, dass innerhalb eines Abtastzyklus, während dem das Messsignal dieses Magnetfeldsensors mit der Phasenregelschleife gekoppelt ist, die Umschalteinrichtung zur Orthogonalumschaltung mindestens zwei und bevorzugt vier unterschiedliche Schaltzustände einnimmt.

8. Vorrichtung (1) nach einem der Ansprüche 1 bis 7, **dadurch gekennzeichnet, dass** die Taktfrequenz des Umschalttaktsignals mindestens eines Magnetfeldsensors (3, 4) derart gewählt ist, dass der Hallsensor-Versorgungsstrom des Magnetfeldsensors nach jedem Rotationsumlauf des Rotationsabtastsignals (10) einmal seine Richtung ändert.

9. Vorrichtung (1) nach einem der Ansprüche 1 bis 8, **dadurch gekennzeichnet, dass** der Komparator (23) einen mit einem Taktsignalgeber verbundenen Taktsignaleingang aufweist, und dass der Taktsignalgeber derart ausgestaltet ist, dass die Taktfrequenz eines an dem Taktsignaleingang anliegenden Komparatortaktsignals mindestens doppelt so groß ist wie die Umlauffrequenz des Rotationsabtastsignals (10).

10. Vorrichtung (1) nach einem der Ansprüche 1 bis 9, **dadurch gekennzeichnet, dass** der Nachlaufoszillator (6) eine der Anzahl der mit ihren Messachsen quer zueinander angeordneten Magnetfeldsensoren (3, 4) entsprechende Anzahl Oszillatorausgänge (7a, 7b) für zueinander phasenverschobene Digitalschwingungssignale aufweist, dass in der Phasenregelschleife eine der genannten Anzahl entsprechende Anzahl Frequenzmischer (19a, 19b) angeordnet sind, dass jeder Frequenzmischer (19a, 19b) jeweils einen mit einem Messsignalausgang (12, 13) eines dem Frequenzmischer (19a, 19b) zugeordneten Magnetfeldsensors (3, 4) verbundenen ersten Eingang und einen mit einem der Oszillatorausgänge (7a, 7b) verbundenen zweiten Eingang aufweist, und dass Mischerausgänge der Frequenzmischer (7a, 7b) über ein Addierglied (29), mindestens einen Tiefpass (22) und wenigstens einen getakteten Komparator (23) an dem Frequenzsteuereingang (9) des Nachlaufoszillators (6) angeschlossen sind.

11. Verfahren zur Messung eines Winkels, unter dem ein Magnetfeld (B) in einer Ebene (2) relativ zu einer Bezugsachse angeordnet ist, wobei eine erste Magnetfeldkomponente (Vₓ) und eine quer dazu angeordnete zweite Magnetfeldkomponente (V_{y}) in und/oder parallel zu der Ebene (2) gemessen werden, und
mit einem PLL-Phasenregelkreis (5) mit einer Phasenregelschleife die Phasenlage eines Digitalschwingungssignals geregelt wird,
**dadurch gekennzeichnet, dass**
die Phasenregelschleife einen Frequenzmischer (19) und einen getakteten Komparator (23), der mit einem Nachlaufoszillator (6) verschaltet ist, aufweist, und von dem Nachlaufoszillator (6), der mindestens einen mit dem Frequenzmischer (19) verbundenen Oszillatorausgang (7) aufweist, das Digitalschwingungssignal (8) erzeugt wird, und
die Phasenlage des Digitalschwingungssignals (8) derart geregelt wird, dass sie zu der Phasenlage eines durch rotierendes Abtasten der Messsignale der Magnetfeldsensoren (3, 4) gebildeten Rotationsabtastsignals (10) phasensynchron ist, und dass der Winkel aus der Phasenlage des Digitalschwingungssignals (8) ermittelt wird.

## Claims

1. Device (1) for measuring an angle at which a magnetic field (B) is arranged in a plane (2) relative to a reference axis, comprising at least two magnetic field sensors (2, 4), which are arranged with the measurement axes thereof in and/or parallel to the plane (2) and are oriented transversely to one another, and a phase-locked-loop phase regulating circuit (5) with a phase regulating loop, **characterised in that** the phase regulating loop comprises a frequency mixer (19) and a cyclic comparator (23) which is connected with a wake oscillator (6), that the wake oscillator (6) has at least one oscillator output (7), which is connected with the frequency mixer (19), for a digital oscillation signal (8), that the magnetic field sensors (3, 4) are so coupled with the phase regulating loop that the digital oscillation signal (8) is synchronous in phase with a rotational scanning signal (10) formed by a rotational scanning of the measurement signals of the magnetic field sensors (3, 4) and that the oscillator output (7) is, for determination of the phase position of the digital oscillation signal (8), connected with a phase position detector.

2. Device (1) according to claim 1, **characterised in that** the magnet field sensors (3, 4) are so connected with a scanning device that the measurement signals of the individual magnetic field sensors (3, 4) can be successively applied to an output terminal (15) for the rotational scanning signal (10), and that the output terminal (15) is connected with a synchronisation signal input of the phase-locked-loop phase regulating circuit (5).

3. Device (1) according to claim 1 or 2, **characterised in that** each magnetic field sensor (3, 4) has a respective measurement signal output connected with an input terminal of a multiplexer (14) and that the multplexer (14) has an output which is connectible with the individual input terminals and which forms the output terminal (15) for the rotational scanning signal (10).

4. Device (1) according to any one of claims 1 to 3, **characterised in that** the output terminal (15) for the rotational scanning signal (10) is connected with a first input of the frequency mixer (19) and the oscillator output (7) of the wake oscillator (6) is connected with a second input of the frequency mixer (19), and that a mixer output (20) of the frequency mixer (19) is connected by way of at least one low-pass filter (22) and the cyclic comparator (23) with a frequency control input (9) of the wake oscillator (6).

5. Device (1) according to any one of claims 1 to 4, **characterised in that** the phase position detector comprises a quadrant detector having a first polarisation detector (27) and a second polarisation detector (28), that an input of the first polarisation detector (27) is connected with a measurement signal output (12) of a first magnetic field sensor (3) and an input of the second polarisation detector (28) is connected with a measurement signal output (13) of a second magnetic field sensor (4), and that the second magnetic field sensor (4) is arranged with the measurement axis thereof orthogonal to the measurement axis of the first magnetic field sensor (3).

6. Device (1) according to any one of claims 1 to 5, **characterised in that** the magnetic field sensors (3, 4) are Hall sensors which comprise a switchover device for orthogonal switching-over of the Hall sensor supply current and the Hall voltage taps and that the switchover device comprises a clock input, which is connected with a pulse transmitter, for a switchover clock signal.

7. Device (1) according to any one of claims 1 to 6, **characterised in that** the clock frequency of the switchover clock signal is so selected by means of at least one magnetic field sensor (3, 4) that within a scanning cycle during which the measurement signal of this magnetic field sensor is coupled with the phase regulating loop the switchover device for the orthogonal switching-over adopts at least two and preferably four different switching states.

8. Device (1) according to any one of claims 1 to 7, **characterised in that** the clock frequency of the switchover clock signal of at least one magnetic field sensor (3, 4) is so selected that the Hall sensor supply current of the magnetic field sensor changes once in its direction after each rotational revolution of the rotational scanning signal (10).

9. Device (1) according to any one of claims 1 to 8, **characterised in that** the comparator (23) comprises a clock signal input connected with a clock signal transmitter and that the clock signal transmitter is so designed that the clock frequency of a comparator clock signal applied to the clock signal input is at least twice as large as the frequency of revolution of the rotational scanning signal (10).

10. Device (1) according to any one of claims 1 to 9, **characterised in that** the wake oscillator (6) comprises a number, which corresponds with the number of magnetic field sensors (3, 4) arranged with the measurement axes thereof transversely to one another, of oscillator outputs (7a, 7b) for digital oscillation signals mutually displaced in phase, that in the phase regulating loop a number, which corresponds with the said number, of frequency mixers (19a, 19b) is arranged, that each frequency mixer (19a, 19b) has a respective first input connected with a measurement signal output (12, 13) of a magnetic field sensor (3, 4) associated with the frequency mixer (19a, 19b) and a second input connected with one of the oscillator outputs (7a, 7b) and that mixer outputs of the frequency mixers (19a, 19b) are connected with the frequency control input (9) of the wake oscillator (6) by way of a summating element (29), at least one low-pass filter (22) and at least one cyclic comparator (23).

11. Method of measuring an angle at which a magnetic field (B) is arranged in a plane (2) relative to a reference axis, wherein a first magnetic field component (Vₓ) and a second magnetic field component (V_{y}) arranged transversely thereto are measured in and/or parallel to the plane (2), and the phase position of a digital oscillation signal is regulated by a phase-locked-loop phase regulating circuit (5) with a phase regulating loop, **characterised in that** the phase regulating loop comprises a frequency mixer (19) and a cyclic comparator (23) which is connected with a wake oscillator (6), and the digital oscillation signal (8) is generated by the wake oscillator (6), which has at least one oscillator output (7) connected with the frequency mixer (19), and the phase position of the digital oscillation signal (8) is so regulated that it is synchronous in phase with the phase position of a rotational scanning signal (10) formed by rotational scanning of the measurement signals of the magnetic field sensors (3, 4), and that the angle is determined from the phase position of the digital oscillation signal (8).

## Revendications

1. Dispositif (1) de mesure d'un angle, selon lequel un champ magnétique (B) est agencé dans un plan (2) par rapport à un axe de référence, avec au moins deux capteurs de champ magnétique (2, 4), disposés avec leurs axes de mesure dans et/ou parallèlement au plan (2) et orientés perpendiculairement les uns par rapport aux autres, avec un circuit de régulation de phase PLL (5) comportant une boucle de régulation de phase,
**caractérisé en ce que**
la boucle de régulation de phase présente un mélangeur de fréquences (19) et un comparateur (23) cadencé, en circuit avec un oscillateur de poursuite (6), **en ce que** l'oscillateur de poursuite (6) présente au moins une sortie d'oscillateur (7), reliée au mélangeur de fréquences (19), pour un signal d'oscillation numérique (8), **en ce que** les capteurs de champ magnétique (3, 4) sont couplés au circuit de régulation de phase, de manière à ce que le signal d'oscillation numérique (8) soit en synchronisme de phase avec un signal d'exploration rotative (10) formé par exploration rotative des signaux de mesure des capteurs de champ magnétique (3, 4), et **en ce que** la sortie d'oscillateur (7) est reliée à un détecteur de position de phase, pour la détermination de la position de phase du signal d'oscillation numérique (8).

2. Dispositif (1) selon la revendication 1, **caractérisé en ce que** les capteurs de champ magnétique (3, 4) sont reliés à un dispositif d'exploration, de manière à ce que les signaux de mesure des différents capteurs de champ magnétique (3, 4) soient susceptibles d'être appliqués, les uns après les autres, à un raccordement de sortie (15) pour le signal d'exploration rotative (10), et **en ce que** le raccordement de sortie (15) est relié à une entrée de signal de synchronisation du circuit de régulation de phase PLL (5).

3. Dispositif (1) selon la revendication 1 ou 2, **caractérisé en ce que** chaque capteur de champ magnétique (3, 4) présente respectivement une sortie de signal de mesure reliée à un raccordement d'entrée d'un multiplexeur (14), et **en ce que** le multiplexeur (14) présente une sortie, susceptible d'être reliée aux différents raccordements d'entrée, formant le raccordement de sortie (15) pour le signal d'exploration rotative (10).

4. Dispositif (1) selon l'une des revendications 1 à 3, **caractérisé en ce que** le raccordement de sortie (15) pour le signal d'exploration rotative (10) est relié à une première entrée du mélangeur de fréquences (19), et la sortie d'oscillateur (7) de l'oscillateur de poursuite (6) est reliée à une deuxième entrée du mélangeur de fréquences (19), et **en ce qu'**une sortie de mélangeur (20) du mélangeur de fréquences (19) est raccordée, par l'intermédiaire d'au moins un filtre passe-bas (22) et du comparateur (23) cadencé, à une entrée de commande en fréquences (9) de l'oscillateur de poursuite (6).

5. Dispositif (1) selon l'une des revendications 1 à 4, **caractérisé en ce que** le détecteur de position de phase présente un détecteur à quadrants, comprenant un premier détecteur de polarisation (27) et un deuxième détecteur de polarisation (28), **en ce qu'**une entrée du premier détecteur de polarisation (27) est reliée à une sortie de signal de mesure (12) d'un premier capteur de champ magnétique (3) et une entrée du deuxième détecteur de polarisation (28) est reliée à une sortie de signal de mesure (13) d'un deuxième capteur de champ magnétique (4), et **en ce que** le deuxième capteur de champ magnétique (4) est disposé avec son axe de mesure orienté perpendiculairement à l'axe de mesure du premier capteur de champ magnétique (3).

6. Dispositif (1) selon l'une des revendications 1 à 5, **caractérisé en ce que** les capteurs de champ magnétique (3, 4) sont des capteurs à effet Hall, présentant un dispositif de commutation pour la commutation orthogonale du courant d'alimentation de capteur à effet Hall et des prélèvements de tension d'effet Hall, et **en ce que** le dispositif de commutation présente une entrée de cadencement, reliée à un générateur de cadencement, pour un signal de cadencement de commutation.

7. Dispositif (1) selon l'une des revendications 1 à 6, **caractérisé en ce que** la fréquence de cadencement du signal de cadencement de commutation d'au moins un capteur de champ magnétique (3, 4) est choisie telle que, dans un cycle d'exploration, pendant lequel le signal de mesure de ce capteur de champ magnétique est couplé à la boucle de régulation de phase, le dispositif de commutation prend au moins deux et, de préférence, quatre états de commutation différents, par rapport à la commutation orthogonale.

8. Dispositif (1) selon l'une des revendications 1 à 7, **caractérisé en ce que** la fréquence de cadencement du signal de cadencement de commutation d'au moins un capteur de champ magnétique (3, 4) est choisie telle que le courant d'alimentation du capteur à effet Hall du capteur de champ magnétique change une fois de sens après chaque rotation du signal d'exploration rotative (10).

9. Dispositif (1) selon l'une des revendications 1 à 8, **caractérisé en ce que** le comparateur (23) présente une entrée de signal de cadencement reliée à un générateur de signal de cadencement, et **en ce que** le générateur de signal de cadencement est réalisé de manière à ce que la fréquence de cadencement d'un signal de cadencement de comparateur, appliqué à l'entrée de signal de cadencement, est d'au moins deux fois la valeur de la fréquence de rotation du signal d'exploration rotative (10).

10. Dispositif (1) selon l'une des revendications 1 à 9, **caractérisé en ce que** l'oscillateur de poursuite (6) présente un nombre, correspondant au nombre des capteurs de champ magnétique (3, 4) disposés avec leurs axes de mesure perpendiculaires les uns aux autres, de sorties d'oscillateur (7a, 7b) pour des signaux d'oscillation numérique mutuellement déphasés, **en ce qu'**un nombre, correspondant au nombre cité, de mélangeurs de fréquences (19a, 19b) sont disposés dans la boucle de régulation de phase, **en ce que** chaque mélangeur de fréquences (19a, 19b) présente une première entrée, reliée à une sortie de signal de mesure (12, 13) d'un capteur de champ magnétique (3, 4) associé au mélangeur de fréquences (19a, 19b), et une deuxième entrée, reliée à l'une des sorties d'oscillateur (7a, 7b), et **en ce que** des sorties de mélangeur des mélangeurs de fréquences (19a, 19b) sont raccordées, par l'intermédiaire d'un organe additionneur (29), d'au moins un filtre passe-bas (22) et d'au moins un comparateur (23) cadencé, à l'entrée de commande en fréquence (9) de l'oscillateur de poursuite (6).

11. Procédé de mesure d'un angle, selon lequel un champ magnétique (B) est agencé dans un plan (2) par rapport à un axe de référence, une première composante de champ magnétique (Vx) et une deuxième composante de champ magnétique (Vy), lui étant perpendiculaires sont mesurées dans et/ou parallèlement au plan (2), et la position de phase d'un signal d'oscillation numérique est régulée à l'aide d'un circuit de régulation de phase PLL (5), avec une boucle de régulation de phase,
**caractérisé en ce que** la boucle de régulation de phase présente un mélangeur de fréquences (19) et un comparateur (23) cadencé, branché avec un oscillateur de poursuite (6), et le signal d'oscillation numérique (8) est généré par l'oscillateur de poursuite (6), qui présente au moins une sortie d'oscillateur (7) reliée au mélangeur de fréquences (19), et **en ce que**
la position de phase du signal d'oscillation numérique (8) est régulée de manière à ce qu'elle soit en synchronisme de phase par rapport à la position de phase d'un signal d'exploration rotative (10) formé par exploration rotative des signaux de mesure des capteurs de champ magnétique (3, 4), et **en ce que** l'angle est déterminé à partir de la position de phase du signal d'oscillation numérique (8).
